# EUROPEAN PATENT APPLICATION

(11) **EP 2 845 888 A1**
(43) Date of publication of application: **11.03.2015**
(21) Application number: 14183748.4
(22) Date of filing: 05.09.2014
(51) Int. Cl.: C09D 153/00, C08F 293/00, C08J 5/18, G03F 7/16, C08L 53/00, G03F 7/06

(54) **Process for producing thick nanostructured films obtained from a block copolymer composition**

(30) Priority: 09.09.2013 FR 1358628; 25.02.2014 FR 1451492
(71) Applicant: ARKEMA FRANCE, 92700 Colombes (FR); CENTRE NATIONAL DE LA RECHERCHE SCIENTIFIQUE, 75794 Paris Cedex 14 (FR); UNIVERSITE DE BORDEAUX, 33000 Bordeaux (FR); Institut Polytechnique de Bordeaux, 33402 Talence Cedex (FR)
(72) Inventor: Navarro, Christophe, 64100 BAYONNE (FR); Chevalier, Xavier, 38100 GRENOBLE (FR); Nicolet, Celia, 64300 ORTHEZ (FR); Iliopoulos, Ilias, 75012 PARIS (FR); Tiron, Raluca, 38950 SAINT-MARTIN-LE-VINOUX (FR); Fleury, Guillaume, 33000 BORDEAUX (FR); Hadziioannou, Georges, 33850 LEOGNAN (FR)
(74) Representative: Albani, Dalila

(57) **Abstract**

The present invention relates to a process for producing nanostructured films obtained from block copolymers exhibiting a dispersity index of between 1.1 and 2, limits included, without nanostructuring defects, on a surface, in order for this treated surface to be able to be used as masks for applications in microelectronics.

## Description

The present invention relates to a process for producing nanostructured films with a thickness of greater than 20 nm obtained from block copolymer compositions exhibiting a dispersity index of between 1.1 and 2, limits included, without nanostructuring defects, on a surface, in order for this treated surface to be able to be used as masks for applications in microelectronics.

Due to their ability to develop a nanostructure, the use of block copolymers in the fields of materials and electronics or optoelectronics is now well known. This novel technology allows access to advanced nanolithographic preparation processes with resolutions in terms of domain size ranging from a few nanometers to several tens of nanometers.

It is in particular possible to structure the arrangement of the blocks making up the copolymers at scales far below 100 nm. Unfortunately, it is often difficult to obtain a film sufficiently thick to be able to be used in lithography applications.

In the case of nanolithography, the desired structuring (for example, generation of the domains perpendicular to the surface) requires specific conditions, such as the preparation of the surface (for example, deposition of a "neutralization" underlayer) but also such as the composition of the block copolymer. Whether it is the chemical nature of the blocks, the ratio by weight of the blocks or their length, an optimization is generally required in order to obtain a morphology as close as possible to the requirements of industry, without defect, and reproducibly. The period of a block copolymer can change according to the conditions of synthesis of the copolymer (more or less great variation in the length of the chains or in the composition), while taking care to retain the targeted morphology. In addition, the dispersity of the block copolymer deposited is generally regarded as a parameter determining the quality of the deposition carried out, in particular the absence of defects and the resolution of the domains. Current knowledge with regard to this specific point is still targeted at the use of block copolymers having the lowest possible dispersity, typically of less than 1.1, in any case as close as possible to 1. In point of fact, such block copolymers can only be accessed directly using anionic polymerization synthesis techniques, which are expensive to carry out at the industrial level.

The applicant company has now discovered that a block copolymer composition, the dispersity of which is not low, that is to say taking values of between 1.1 and 2, provides the following advantages:
- Films obtained by a deposition of block copolymers on a surface can be organized perpendicularly without defects, this being the case independently with respect to the thickness of the film, for dispersity values of the block copolymer composition ranging from 1.1 to 2.
- The use of such block copolymer compositions allows the formation of films of high thickness, typically greater than 40 nm, thus rendering these films particularly advantageous to be able to be used as masks for lithography.
- The process of the invention, which consists in using a block copolymer composition with a dispersity of between 1.1 and 2, makes it possible to carry out the annealing necessary to structure the block copolymer composition at temperatures lower by 30 to 50°C with respect to the temperature used when the block copolymer composition exhibits a low dispersity (typically less than 1.1), or in shorter times.
- Such block copolymer compositions are, for example, accessible by simplified anionic polymerization methods, ring opening polymerization, by controlled or uncontrolled radical polymerization, combination of these polymerization technics methods or also by blending block copolymers.

### Summary of the invention:

The invention relates to a process for producing thick nanostructured films with a minimum of defects, obtained from a block copolymer composition, the dispersity of which exhibits a value of between 1.1 and 2, comprising the following stages:
- preparation of the block copolymer composition, the dispersity of which exhibits a value of between 1.1 and 2,
- deposition of this composition in solution or not on a surface,
- annealing.

### Detailed description:

The term "surface" is understood to mean a surface which can be flat or non-flat. If appropriate, the surface can be treated by a predeposition of random copolymer which facilitates the preferred organization of the block copolymer composition.

The term "annealing" is understood to mean a heating stage which makes possible the evaporation of the solvent, when it is present, and which allows the desired self-organization.

The term "thick film" is understood to mean a film, the thickness of which is between 30 and 300 nm and preferably between 40 and 80 nm.

The term "dispersity" is understood to mean the ratio of the weight-average molecular weight, expressed in g/mol, to the number-average molecular weight, expressed in g/mol. The molecular weights and the dispersity indices, corresponding to the ratio of weight-average molecular weight (Mw) to number-average molecular weight (Mn), are obtained by SEC (Size Exclusion Chromatography), using two Agilent 3 µm ResiPore columns in series, in a THF medium stabilized with BHT, at a flow rate of 1 ml/min, at 40°C, with samples at a concentration of 1 g/l, with prior calibration with graded samples of polystyrene using an Easical PS-2 prepared pack.

The nanostructuring of a block copolymer composition on a surface treated by the process of the invention can take the forms such as cylindrical (hexagonal symmetry (*primitive hexagonal* lattice symmetry "*6 mm*") according to the Hermann-Mauguin notation, or tetragonal symmetry (*primitive tetragonal* lattice symmetry "*4 mm*")), spherical (hexagonal symmetry (*primitive hexagonal* lattice symmetry *"6 mm"* or "*6*/*mmm*"), or tetragonal symmetry (*primitive tetragonal* lattice symmetry "*4 mm*"), or cubic symmetry (lattice symmetry *m⅓m*)), lamellar or gyroidal. Preferably, the preferred form which the nanostructuring takes is of the hexagonal cylindrical, or lamellar type.

The process for the self-assembling of a block copolymer composition on a surface treated according to the invention is governed by thermodynamic laws. When the self-assembling results in a morphology of cylindrical type, each cylinder is surrounded by 6 equidistant neighboring cylinders if there is no defect. Several types of defects can thus be identified. The first type is based on the evaluation of the number of neighbors around a cylinder which constitutes the arrangement of the block copolymer composition, also known as coordination number defects. If five or seven cylinders surround the cylinder under consideration, a coordination number defect will be regarded as being present. The second type of defect considers the mean distance between the cylinders surrounding the cylinder under consideration [W.Li, F.Qiu, Y.Yang and A.C.Shi, Macromolecules, 43, 2644 (2010); K. Aissou, T. Baron, M. Kogelschatz and A. Pascale, Macromol., 40, 5054 (2007); R. A. Segalman, H. Yokoyama and E. J. Kramer, Adv. Matter., 13, 1152 (2003); R. A. Segalman, H. Yokoyama and E. J. Kramer, Adv. Matter., 13, 1152 (2003)]. When this distance between two neighbors is greater than two % of the mean distance between two neighbors, a defect will be regarded as being present. In order to determine these two types of defects, use is conventionally made of the associated Voronoi constructions and Delaunay triangulations. After binarization of the image, the center of each cylinder is identified. The Delaunay triangulation subsequently makes it possible to identify the number of first-order neighbors and to calculate the mean distance between two neighbors. It is thus possible to determine the number of defects. This counting method is described in the paper by Tiron et al. (J. Vac. Sci. Technol. B, 29(6), 1071-1023, 2011).

A final type of defect relates to the angle of cylinders of the block copolymer composition which is deposited on the surface. When the block copolymer composition is no longer perpendicular to the surface but lying down parallel to the latter, a defect of orientation will be regarded as having appeared.

The process of the invention makes it possible to obtain nanostructured assemblages in the form of films with a minimum of defects of orientation, of coordination number or of distance and large microcrystalline surfaces.

Any block copolymer composition, whatever its associated morphology, can be used in the context of the invention, whether diblock, linear or star-branched triblock or linear, comb-shaped or star-branched multiblock copolymer compositions are concerned, provided that they exhibit a dispersity of between 1.1 and 2 and preferably between 1.1 and 1.6, limits included.

Preferably, diblock or triblock copolymer compositions and more preferably diblock copolymer compositions are involved.

These compositions can be synthesized by any technique known to a person skilled in the art, among which may be mentioned polycondensation, ring opening polymerization or anionic, cationic or radical polymerization, or combination of these technics it being possible for these techniques to be controlled or uncontrolled. When the copolymers are prepared by radical polymerization, the latter can be controlled by any known technique, such as NMP ("Nitroxide Mediated Polymerization"), RAFT ("Reversible Addition and Fragmentation Transfer"), ATRP ("Atom Transfer Radical Polymerization"), INIFERTER ("Initiator-Transfer-Termination"), RITP ("Reverse Iodine Transfer Polymerization") or ITP ("Iodine Transfer Polymerization").

According to a preferred form of the invention, the block copolymer compositions are prepared by controlled radical polymerization, more particularly still by nitroxide mediated polymerization, the nitroxide being in particular N-(tert-butyl)-1-diethylphosphono-2,2-dimethylpropyl nitroxide.

According to a second preferred form of the invention, the copolymer compositions are prepared by anionic polymerization.

In both these preferred forms of the invention, care will be taken that the dispersity of the block copolymer composition is between 1.1 and 2 and preferably between 1.1 and 1.6, limits included.

When the polymerization is carried out in radical fashion, the constituent monomers of the block copolymer compositions will be chosen from the following monomers: at least one vinyl, vinylidene, diene, olefinic, allyl or (meth)acrylic monomer. This monomer is more particularly chosen from vinylaromatic monomers, such as styrene or substituted styrenes, in particular α-methylstyrene, silylated styrenes, acrylic monomers, such as acrylic acid or its salts, alkyl, cycloalkyl or aryl acrylates, such as methyl, ethyl, butyl, ethylhexyl or phenyl acrylate, hydroxyalkyl acrylates, such as 2-hydroxyethyl acrylate, ether alkyl acrylates, such as 2-methoxyethyl acrylate, alkoxy- or aryloxypolyalkylene glycol acrylates, such as methoxypolyethylene glycol acrylates, ethoxypolyethylene glycol acrylates, methoxypolypropylene glycol acrylates, methoxypolyethylene glycol-polypropylene glycol acrylates or their mixtures, aminoalkyl acrylates, such as 2-(dimethylamino)ethyl acrylate (ADAME), fluoroacrylates, silylated acrylates, phosphorus-comprising acrylates, such as alkylene glycol acrylate phosphates, glycidyl acrylate or dicyclopentenyloxyethyl acrylate, methacrylic monomers, such as methacrylic acid or its salts, alkyl, cycloalkyl, alkenyl or aryl methacrylates, such as methyl (MMA), lauryl, cyclohexyl, allyl, phenyl or naphthyl methacrylate, hydroxyalkyl methacrylates, such as 2-hydroxyethyl methacrylate or 2-hydroxypropyl methacrylate, ether alkyl methacrylates, such as 2-ethoxyethyl methacrylate, alkoxy-or aryloxypolyalkylene glycol methacrylates, such as methoxypolyethylene glycol methacrylates, ethoxypolyethylene glycol methacrylates, methoxypolypropylene glycol methacrylates, methoxypolyethylene glycol-polypropylene glycol methacrylates or their mixtures, aminoalkyl methacrylates, such as 2-(dimethylamino)ethyl methacrylate (MADAME), fluoromethacrylates, such as 2,2,2-trifluoroethyl methacrylate, silylated methacrylates, such as 3-methacryloyloxypropyltrimethylsilane, phosphorus-comprising methacrylates, such as alkylene glycol methacrylate phosphates, hydroxyethylimidazolidone methacrylate, hydroxyethylimidazolidinone methacrylate or 2-(2-oxo-1-imidazolidinyl)ethyl methacrylate, acrylonitrile, acrylamide or substituted acrylamides, 4-acryloylmorpholine, N-methylolacrylamide, methacrylamide or substituted methacrylamides, N-methylolmethacrylamide, methacrylamidopropyltrimethylammonium chloride (MAPTAC), glycidyl methacrylate, dicyclopentenyloxyethyl methacrylate, itaconic acid, maleic acid or its salts, maleic anhydride, alkyl or alkoxy- or aryloxypolyalkylene glycol maleates or hemimaleates, vinylpyridine, vinylpyrrolidinone, (alkoxy)poly(alkylene glycol) vinyl ethers or divinyl ethers, such as methoxypoly(ethylene glycol) vinyl ether or poly(ethylene glycol) divinyl ether, olefinic monomers, among which may be mentioned ethylene, butene, hexene and 1-octene, diene monomers, including butadiene or isoprene, as well as fluoroolefinic monomers and vinylidene monomers, among which may be mentioned vinylidene fluoride, alone or as a mixture of at least two abovementioned monomers.

Preferably, the block copolymer compositions consist of block copolymer compositions, one of the blocks of which comprises styrene and the other block of which comprises methyl methacrylate.

When the polymerization is carried out in anionic fashion, use will be made of an anionic polymerization process in a nonpolar solvent and preferably toluene, as described in the patent EP 0 749 987, and which involves a micromixer. The monomers chosen from the following entities will be favored: at least one vinyl, vinylidene, diene, olefinic, allyl or (meth)acrylic monomer. These monomers are more particularly chosen from vinylaromatic monomers, such as styrene or substituted styrenes, in particular α-methylstyrene, silylated styrenes, acrylic monomers, such as alkyl, cycloalkyl or aryl acrylates, such as methyl, ethyl, butyl, ethylhexyl or phenyl acrylate, ether alkyl acrylates, such as 2-methoxyethyl acrylate, alkoxy- or aryloxypolyalkylene glycol acrylates, such as methoxypolyethylene glycol acrylates, ethoxypolyethylene glycol acrylates, methoxypolypropylene glycol acrylates, methoxypolyethylene glycol-polypropylene glycol acrylates or their mixtures, aminoalkyl acrylates, such as 2-(dimethylamino)ethyl acrylate (ADAME), fluoroacrylates, silylated acrylates, phosphorus-comprising acrylates, such as alkylene glycol acrylate phosphates, glycidyl acrylate or dicyclopentenyloxyethyl acrylate, alkyl, cycloalkyl, alkenyl or aryl methacrylates, such as methyl (MMA), lauryl, cyclohexyl, allyl, phenyl or naphthyl methacrylate, ether alkyl methacrylates, such as 2-ethoxyethyl methacrylate, alkoxy- or aryloxypolyalkylene glycol methacrylates, such as methoxypolyethylene glycol methacrylates, ethoxypolyethylene glycol methacrylates, methoxypolypropylene glycol methacrylates, methoxypolyethylene glycol-polypropylene glycol methacrylates or their mixtures, aminoalkyl methacrylates, such as 2-(dimethylamino)ethyl methacrylate (MADAME), fluoromethacrylates, such as 2,2,2-trifluoroethyl methacrylate, silylated methacrylates, such as 3-methacryloyloxypropyltrimethylsilane, phosphorus-comprising methacrylates, such as alkylene glycol methacrylate phosphates, hydroxyethylimidazolidone methacrylate, hydroxyethylimidazolidinone methacrylate or 2-(2-oxo-1-imidazolidinyl)ethyl methacrylate, acrylonitrile, acrylamide or substituted acrylamides, 4-acryloylmorpholine, N-methylolacrylamide, methacrylamide or substituted methacrylamides, N-methylolmethacrylamide, methacrylamidopropyltrimethylammonium chloride (MAPTAC), glycidyl methacrylate, dicyclopentenyloxyethyl methacrylate, maleic anhydride, alkyl or alkoxy- or aryloxypolyalkylene glycol maleates or hemimaleates, vinylpyridine, vinylpyrrolidinone, (alkoxy)poly(alkylene glycol) vinyl ethers or divinyl ethers, such as methoxypoly(ethylene glycol) vinyl ether or poly(ethylene glycol) divinyl ether, olefinic monomers, among which may be mentioned ethylene, butene, hexene and 1-octene, diene monomers, including butadiene or isoprene, as well as fluoroolefinic monomers and vinylidene monomers, among which may be mentioned vinylidene fluoride, lactones, lactides, glycolides, cyclic carbonates or siloxanes, if appropriate protected in order to be compatible with the anionic polymerization processes, alone or as a mixture of at least two abovementioned monomers.

According to an alternative form of the invention, consideration will be given to block copolymers, one of the blocks of which comprises styrene and at least one comonomer X, the other block of which comprising methyl methacrylate and at least one comonomer Y, X being chosen from the following entities: styrene, which is hydrogenated or partially hydrogenated, cyclohexadiene, cyclohexene, styrene substituted by one or more fluoroalkyl or silylated alkyl groups, or their mixtures, in proportions by weight of X ranging from 1% to 99% and preferably from 2% to 20%, with respect to the block comprising styrene; Y being chosen from the following entities: fluoroalkyl (meth)acrylate, particularly trifluoroethyl methacrylate, dimethylaminoethyl (meth)acrylate, globular (meth)acrylates, such as isobornyl (meth)acrylate or halogenated isobornyl (meth)acrylate, halogenated alkyl (meth)acrylate, naphthyl (meth)acrylate, trimethylsilyl (meth)acrylate, polyhedral oligomeric silsesquioxane (meth)acrylate, which can comprise a fluorinated group, or their mixtures, in proportions by weight of Y ranging from 1% to 99% and preferably from 2% to 20%, with respect to the block comprising methyl methacrylate.

The block copolymer compositions used in the invention can also be prepared by blending, in all proportions, block copolymers with the same composition but exhibiting different (number- or weight-average) molecular weights and dispersities of each block copolymer of between 1.1 and 2. It will thus be possible to blend between 2 and 10 block copolymers, limits included, preferably between 2 and 4, limits included, and more preferably between 2 and 3, limits included. Reference will be made to block copolymer composition, it being understood that it will in fact consist of a blend of block copolymers which are obtained by as much synthesis as the number of block copolymers which it is desired to blend. For this reason, the steric exclusion chromatograms may exhibit a multimodality of molecular weight distribution, ie chromatograms exhibiting several maxima, like several pattern Gaussian or not..

The block copolymer compositions used in the invention exhibit the following characteristics:
A number-average molecular weight of between 1000 and 300 000 g/mol and preferably between 10 000 and 250 000, more preferably between 32000 and 15000 and a dispersity index of between 1 and 3, preferably between 1.1 and 2 and even more preferably between 1.1 and 1.5.

The block copolymer compositions used in the context of the invention can be deposited on a surface from solutions of the block copolymer compositions under consideration, dissolved in one or more solvents, among which may be mentioned propylene glycol monomethyl ether acetate (PGMEA), ethoxyethyl propionate, anisole or toluene. Preferably, the solvent is PGMEA.

The block copolymer compositions used in the context of the invention can comprise one or more additives, such as a surfactant, UV stabilizer or antioxidant, a compound which makes possible crosslinking or a UV-sensitive initiator.

The block copolymer compositions deposited on films can be used in various applicative processes, such as lithography (lithography masks), the manufacture of membranes, the functionalization and coating of surfaces, the manufacture of inks and composites, the nanostructuring of surfaces, the manufacture of transistors, diodes, or organic memory cells.

The invention relates in particular to the use of the process which is a subject matter of the invention to manufacture lithography masks, and to the masks obtained or to manufacture nanostructured film at nanometer scale and the films thus obtained.

The process of the invention makes it possible to obtain thick films, typically of greater than or equal to 20 nm, preferably greater or equal to 30 nm, and more preferably greater or equal to 40 nm with fewer defects, whether these are defects of orientation of the block copolymers deposited, coordination number defects or distance defects. Thus, the process of the invention makes possible the manufacture of films with greater monocrystalline surfaces compared with those obtained with a single block copolymer of low dispersity (typically less than 1.1). The term "monocrystalline surface" is understood to mean a surface where the morphology of the block copolymer (or of the block copolymers) deposited is perfectly ordered, without defect of orientation, of distance or of coordination number, exhibiting a long-range periodic or quasiperiodic translational order, typically several times the intrinsic period/unit cell of the block copolymer (or of the block copolymers), whatever the chosen direction of the surface, and the boundary of which is delimited by defects, whether defects of orientation, of distance or of coordination number.

In the case of lithography, the desired structuring (for example, generation of the domains perpendicular to the surface) requires, however, the preparation of the surface on which the block copolymer composition is deposited for the purpose of controlling the surface energy. Among the known possibilities, a random copolymer, the monomers of which can be identical, in all or part, to those used in the block copolymer composition which it is desired to deposit, is deposited on the surface. In a pioneering paper, Mansky et al. (Science, Vol. 275, pages 1458-1460, 1997) give a good description of this technology, now well known to a person skilled in the art.

Mention may be made, among the favored surfaces, of the surfaces composed of silicon, the silicon exhibiting a native or thermal oxide layer, germanium, platinum, tungsten, gold, titanium nitrides, graphenes, BARC (Bottom Anti-Reflective Coating) or any other antireflective layer used in lithography.

The surfaces can be said to be "free" (flat and homogeneous surface, both from a topographical and from a chemical viewpoint) or can exhibit structures for guidance of the block copolymer "pattern", whether this guidance is of the chemical guidance type (known as "guidance by chemical epitaxy") or physical/topographical guidance type (known as "guidance by graphoepitaxy").

Once the surface has been prepared, a solution of the block copolymer composition is deposited and then the solvent is evaporated according to techniques known to a person skilled in the art, such as, for example, the spin coating, doctor blade, knife system or slot die system technique, but any other technique can be used, such as dry deposition, that is to say deposition without involving a predissolution.

A heat treatment or treatment by solvent vapor, a combination of the two treatments, or any other treatment known to a person skilled in the art which allows the block copolymer composition to become correctly organized, is subsequently carried out.

The following examples nonlimitingly illustrate the scope of the invention:
The solutions of block copolymers are deposited on a surface in the following way:
   Preparation of the surface, grafting to SiO₂:
      Silicon wafers (crystallographic orientation {100}) are cut up manually into 3 x 4 cm pieces and cleaned by piranha treatment (H₂SO₄/H₂O₂ 2:1 (*v:v*)) for 15 minutes, then rinsed with deionized water and dried under a stream of nitrogen immediately before functionalization. The continuation of the procedure is that described by Mansky et al. (Science, 1997, 1458), with just one modification (the annealing is carried out under ambient atmosphere and not under vacuum). A random PS-*r*-PMMA copolymer with a molecular weight of 12 280 g/mol and with a PS/PMMA ratio of 74/26, prepared by radical polymerization controlled using the NMP technology, according to a protocol described in WO20121400383, example 1 and example 2 (copolymer 11), allowing the neutralization of the surface, is dissolved in toluene in order to obtain 1.5% by weight solutions. This solution is dispensed by hand over a freshly cleaned wafer and then spread by spin coating at 700 revolutions/min in order to obtain a film with a thickness of approximately 90 nm. The substrate is then simply deposited on a heating plate, brought beforehand to the desired temperature, under ambient atmosphere for a variable time. The substrate is then washed by sonication in several toluene baths for a few minutes, in order to remove the ungrafted polymer from the surface, and then dried under a stream of nitrogen. It may be noted that, throughout this procedure, the toluene can be replaced without distinction by PGMEA.

Any other copolymer can be used, typically a random P(MMA-co-styrene) copolymer as used by Mansky, provided that the styrene and MMA composition is chosen to be appropriate for neutralization.

Three solutions of polymers are used (at 1% in PGMEA), available from Arkema under the name Nanostrengh EO^{®}, specifically the C23, C35 and C50 grades, respectively exhibiting periods, once individually deposited on a surface, of 23.05, 34.3 and 49.7 nm for equivalent film thicknesses.

The term "period" is understood to mean the minimum distance separating two neighboring domains having the same chemical composition, separated by a domain having a different chemical composition (distance between centers of adjacents nanodomains).

These block copolymers are PS-*b*-PMMA copolymers prepared according to a protocol described in EP 0 749 987, EP 0 749 987 and EP 0 524 054, with recovery of the block copolymer under consideration by precipitation from a nonsolvent on conclusion of the synthesis, such as an 80/20 by volume mixture of cyclohexane/heptane.

They exhibit the following characteristics:

| | Mₙ (kg/mol) | M_{w} (kg/mol) | Dispersity |
|---|---|---|---|
| C23 | 28.5 | 31.0 | 1.09 |
| C35 | 50.2 | 54.5 | 1.09 |
| C50 | 83.1 | 90.1 | 1.08 |
| C23:C50 3:7 | 43.7 | 54.2 | 1.24 |
| C23:C35:C50 1:1:1 | 46.7 | 61.4 | 1.32 |

PS/PMMA ratio by weight = 69/31
C23:C50 and C23:C35:C50 are obtained by mixing, by volume, the solutions of block copolymers, all the starting solution being at the same concentration.
The molecular weights and the dispersity indices, corresponding to the ratio of weight-average molecular weight (Mw) to number-average molecular weight (Mn), are obtained by SEC (Size Exclusion Chromatography), using two Agilent 3 µm ResiPore columns in series, in a THF medium stabilized with BHT, at a flow rate of 1 ml/min, at 40°C, with samples at a concentration of 1 g/l, with prior calibration with graded samples of polystyrene using an Easical PS-2 prepared pack.

The PS/PMMA ratio by weight is obtained by proton NMR on a Bruker 400 device by integrating the 5 aromatic protons of the PS and the 3 protons of the methoxy of the PMMA.

The measurements of film thickness were carried out on a Prometrix UV1280 ellipsometer.

The invention can also be carried out using other block copolymers of other origin.

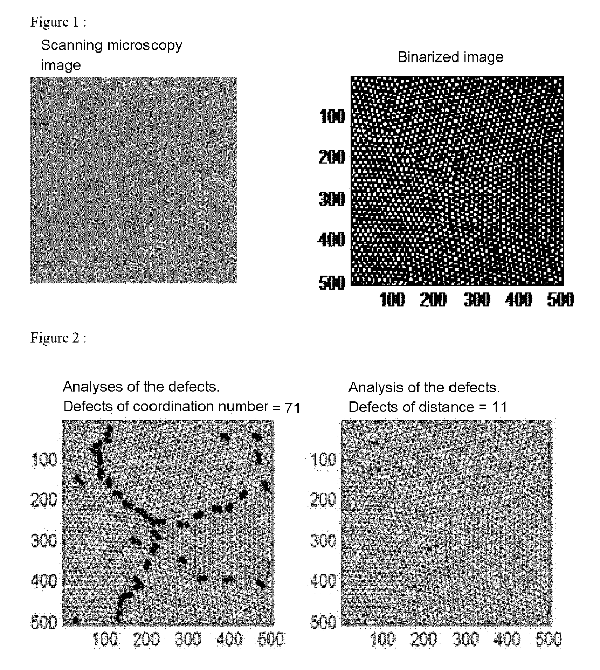

The scanning microscopy (SEM) image of a film with a thickness of 40 nm for the composition C23:C50 3:7, and also its binarization, are visualized in figure 1.

The analysis of the defects of coordination number and of distance as described in the description is visible in figure 2. 71 defects of coordination number and 11 defects of distance are counted.

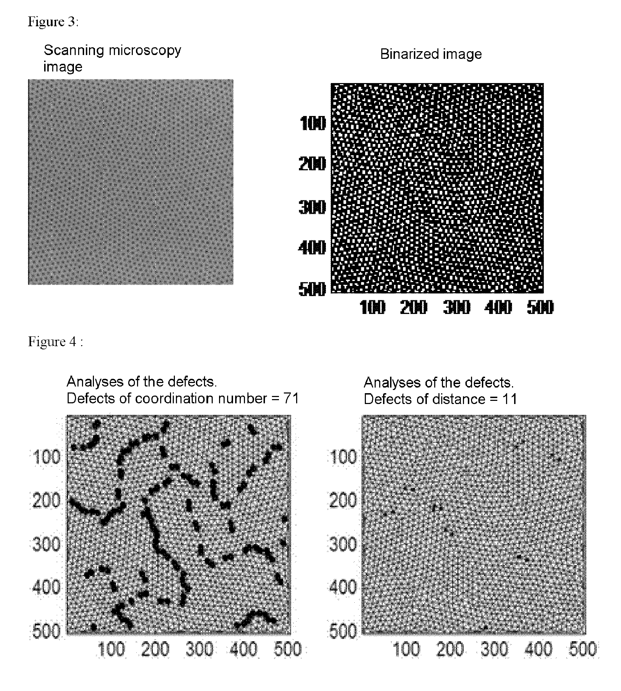

The scanning microscopy (SEM) image of the composition C35, and also its binarization, are visualized in figure 3.

The analysis of the defects of coordination number and of distance as described in the description is visible in figure 4.
140 defects of coordination number and 16 defects of distance are counted.

The composition C23:C50, exhibiting a dispersity index of 1.24, exhibits far fewer defects than the composition C35, exhibiting a dispersity index of 1.09.

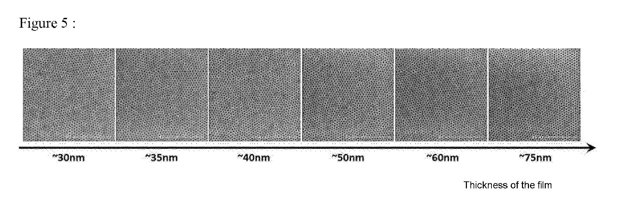

The composition C23:C35:C50, which exhibits a dispersity index of 1.32, deposited as films of variable thickness, is considered in figure 5. Whatever the thickness of the film, it may be observed that the films are devoid of defects.

## Claims

1. A process for producing thick nanostructured films and with a minimum of defects, obtained from a block copolymer composition, the dispersity of which exhibits a value of between 1.1 and 2, comprising the following stages:
- preparation of the block copolymer composition, the dispersity of which exhibits a value of between 1.1 and 2,
- deposition of this composition in solution or not on a surface,
- annealing.

2. The process as claimed in claim 1, in which the films obtained exhibit a minimum of defects of orientation, of coordination number or of distance and large monocrystalline surfaces.

3. The process as claimed in claim 1 or 2, in which the number-average molecular weight of the block copolymer composition is between 1000 and 300 000 g/mol.

4. The process as claimed in claim 1 or 2, in which the number-average molecular weight of the block copolymer composition is between 1000 and 300 000 g/mol.

5. the process of claim 1 or 2, in which the composition exhibit multimodal chromatogram.

6. The process as claimed in claim 1 or 2, in which the block copolymer composition is a diblock copolymer composition.

7. The process as claimed in claim 6, in which the block copolymer composition consists PS-PMMA diblock copolymers.

8. The process as claimed in claim 1 or 2, in which the block copolymer composition is prepared by controlled radical polymerization.

9. The process as claimed in claim 8, in which nitroxide mediated radical polymerization is carried out.

10. The process as claimed in claim 9, in which nitroxide mediated radical polymerization is carried out, the nitroxide being N-(tert-butyl)-1-diethylphosphono-2,2-dimethylpropyl nitroxide.

11. The process as claimed in claim 1 or 2, in which the block copolymer composition is prepared by anionic polymerization.

12. The process as claimed in claim 1 or 2, in which the block copolymer composition is prepared by ring opening polymerization.

13. The process as claimed in claim 1 or 2, in which the block copolymer composition is prepared by blending several block copolymers.

14. The process as claimed in claim 1 or 2, in which the thickness of the film is between 20 and 300 nm.

15. The process as claimed in claim 1 or 2, in which the surface is free.

16. The process as claimed in claim 1 or 2, in which the surface exhibits guidance structures.

17. The process as claimed in claim 1 or 2, in which the annealing is carried out by a heat treatment.

18. The process as claimed in claim 1 or 2, in which the annealing is carried out by a solvent vapor treatment.

19. The process as claimed in claim 1 or 2, in which the annealing is carried out by a combination of a heat treatment and a solvent vapor treatment.

20. The use of the process as claimed in any one of the preceding claims to generate lithography masks or nanostructured film at nanometer scale.

21. A lithography mask obtained according to claim 20.
